Europäisches Patentamt

European Patent Office

Office européen des brevets

(11) Veröffentlichungsnummer: **0 279 208 B1**

# EUROPÄISCHE PATENTSCHRIFT

(45) Veröffentlichungstag der Patentschrift: **08.12.93**

(51) Int. Cl.⁵: $H03H$ **17/06**

(21) Anmeldenummer: **88100928.6**

(22) Anmeldetag: **22.01.88**

(54) **Nichtrekursives Halb-Band-Filter.**

(30) Priorität: **19.02.87 DE 3705209**

(43) Veröffentlichungstag der Anmeldung:
**24.08.88 Patentblatt 88/34**

(45) Bekanntmachung des Hinweises auf die
Patenterteilung:
**08.12.93 Patentblatt 93/49**

(84) Benannte Vertragsstaaten:
**AT CH FR GB IT LI SE**

(56) Entgegenhaltungen:
**EP-A- 0 290 790**

**IEEE TRANSACTIONS ON COMMUNICA-
TIONS, Band COM-30, Nr. 7, Teil 1, Juli 1982,
Seiten 1629-1641, IEEE, New York, US; A.G.
CONSTANTINIDES et al.: "An efficient and
modular transmultiplexer design"**

**IEEE TRANS. ON COMMUNICATONS, Band
COM-28, Nr. 9, Teil II, September 1980, Seiten
1709-1716, IEEE, New York, US; T. AOYAMA et
al.: "120-Channel transmultiplexer design
and performance"**

**RADIOELECTRONICS & COMMUNICATIONS
SYSTEMS, Band 29, Nr. 4, 1986, Seiten 43-48,**

**Allerton Press, Inc., New York, NY, US; V.I.
BITYUTSKII et al.: "Use of complex digital
filtration for detection of signals with singlesideband modulation"**

(73) Patentinhaber: **ANT Nachrichtentechnik GmbH
Gerberstrasse 33
D-71522 Backnang(DE)**

(72) Erfinder: **Göckler, Heinz, Dipl.-Ing.
Elbinger Strasse 52
D-7150 Backnang(DE)**

**Beschreibung**

Die Erfindung geht aus von einem nichtrekursiven Halb-Band-Filter gemäß Oberbegriff des Anspruches 1 oder 2. Solche Filter sind bekannt geworden durch den Aufsatz "Interpolation, Extrapolation, and Reduction of Computation Speed in Digital Filters" von Bellanger et al in IEEE Transactions an Acoustics, Speech and Signal Processing, Vol. ASSP-22, Nr. 4, Aug. 74, S. 231 ff.

Die bekannten Halb-Band-Filter verarbeiten reelle Eingangssignale zu reellen Ausgangssignalen.

Im deutschen Patent P 36 21 737 wurde ein nichtrekursives Halb-Band-Filter angegeben, welches die Umwandlung eines reellen Eingangssignals in ein komplexes Ausgangssignal oder umgekehrt gestattet, indem ein komplexer Träger mit der Impulsantwort des Filters moduliert wird.

Der vorliegenden Erfindung lag die folgende Aufgabe zugrunde, ein nichtrekursives Halb-Band-Filter anzugeben, welches die Umwandlung eines komplexwertigen Eingangssignals in ein komplexwertiges Ausgangssignal in wenig aufwendiger Weise ermöglicht.

Die Lösung erfolgt mit Den Merkmalen des Anspruches 1 bzw. 2.

Das erfindungsgemäße nichtrekursive Halb-Band-Filter gestattet die Umwandlung komplexer digitaler Eingangssignale in komplexe digitale Ausgangssignale bei gleichzeitiger Verminderung der Abtastfrequenz um den Faktor 2 bzw. die Umwandlung komplexer digitaler Eingangssignale in komplexe digitale Ausgangssignale bei gleichzeitiger Erhöhung der Abtastfrequenz um den Faktor 2. Dieses relativ unaufwendige Halb- Band-Filter eignet sich damit als digitales Vorfilter oder Nachfilter für digitale Systeme zur Verarbeitung komplexer Signale und als digitale Teilfilter einer Anordnung von Antialiasing Filtern zur Bandbegrenzung unter Erfüllung des Abtasttheorems. Der Vorteil des Halb-Band-Filters liegt in der linearen Phase und in dem gleichzeitig geringen Aufwand, wobei jeweils die aufgrund des Abtasttheorems erforderliche minimal mögliche Abtastfrequenz verwendet werden kann.

Es folgt nun die Beschreibung anhand der Figuren.

Die Figur 1 zeigt das Blockschaltbild des erfindungsgemäßen Digitalfilters.

In Figur 2a bis 2c sind einige Amplitudenantworten von Halb-Band-Filtern über der Frequenz aufgetragen.

Die Figuren 3 und 4 zeigen besonders günstige Schaltungsvarianten des Halb-Band-Filters.

In Figur 5 schließlich ist das Blockschaltbild eines Halb-Band-Filters zur Verarbeitung eines komplexen Eingangssignals in ein komplexes Ausgangssignal bei gleichzeitiger Erhöhung der Abtastrote um den Faktor 2 gezeichnet.

Die Figur 6 zeigt die detaillierte Schaltung des Filters nach Fig. 5, wobei diese Schaltung aus der Figur 3 durch Transposition entwickelt wurde, d.h. durch Umkehrung aller Pfeilrichtungen und den Ersatz einer Verzweigung durch einen Addierer und umgekehrt und den Ersatz eines Demultiplexers durch einen Multiplexer.

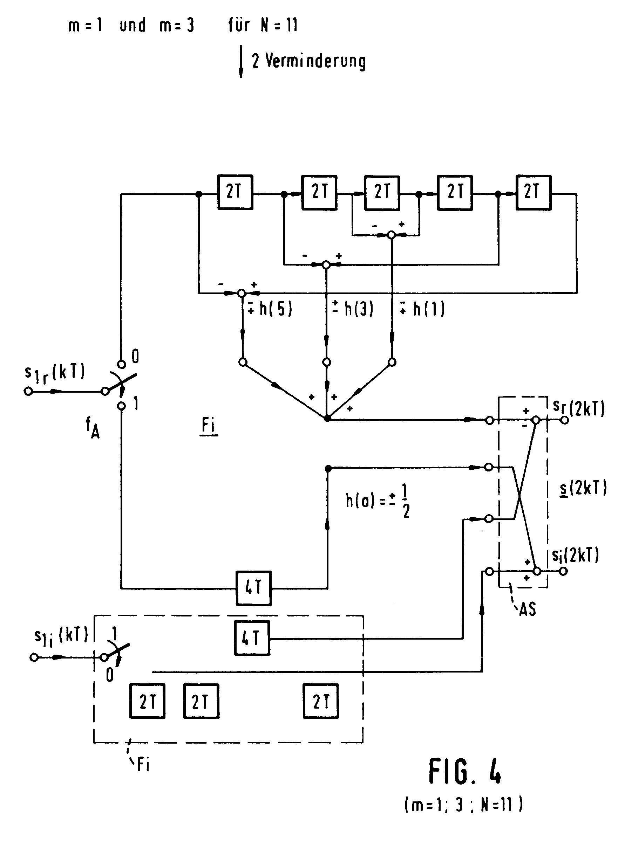

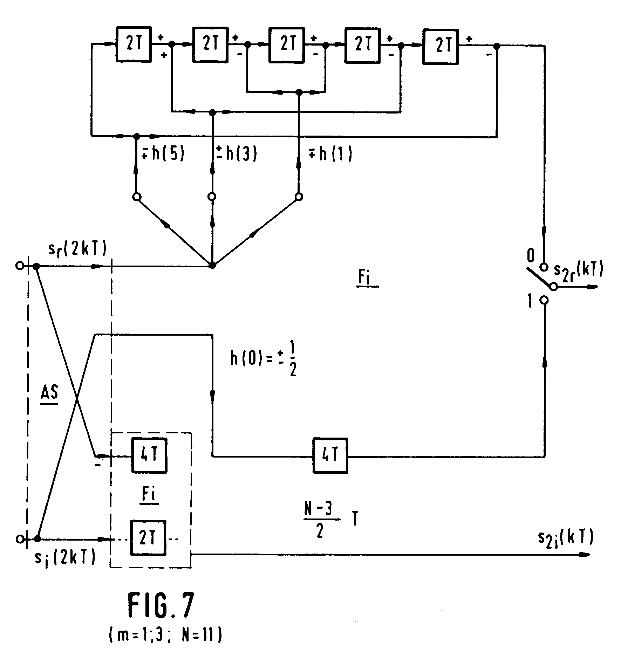

In entsprechender Weise ist die Schaltung nach Figur 7 aus der der Figur 4 entstanden.

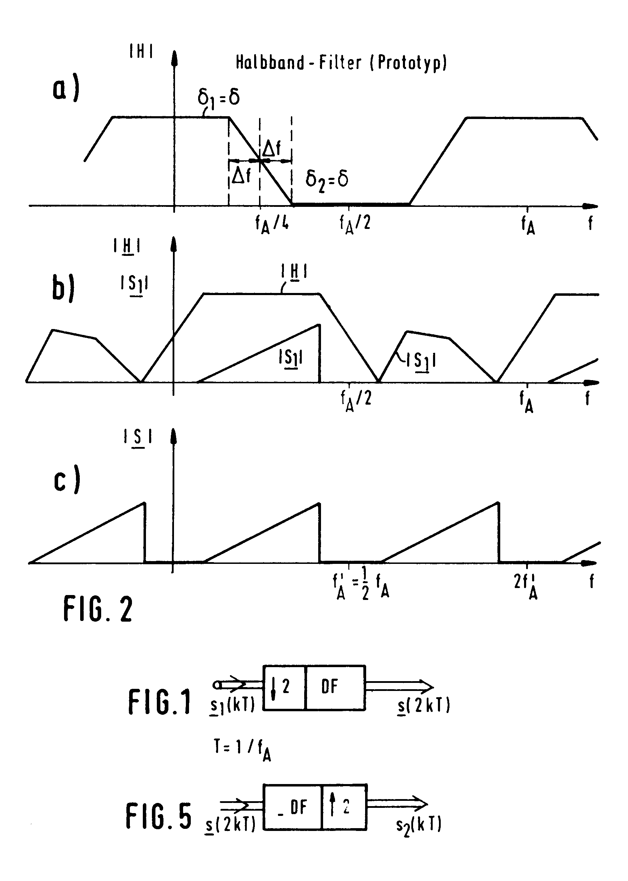

In Figur 1 wird das komplex-wertige Eingangssignal $s_1(kT)$ durch Halbierung der Abtastrate dem digitalen Halb-Band-Filter DF zugeführt, welches daraus das komplexe Ausgangssignal $s(2kT)$ erzeugt.

In Figur 2a ist die Amplitudenfrequenzantwort eines Prototyp-Halb-Band-Filter erkennbar, sein Durchlaßbereich reicht von -fA/4 + Δf bis + fA/4 - Δf (Halbwert), und sein Sperrbereich ist ebenfalls fA/2 - 2Δf breit. Kennzeichnend für das Halb-Band-Filter ist weiterhin, daß der Übergang vom Sperr- zun Durchlaßbereich stetig ist und auf einer Breite von 2 f erfolgt. Dieser Übergangsbereich ist symmetrisch zu fA/4 angeordnet. Ein weiteres Kennzeichen des Halb-Band-Filters ist, daß sein Ripple im Durchlaß- und Sperrbereich gleich ist, nämlich $\delta1 = \delta2 = \delta$. Bei einem solchen Filter ergibt sich eine Impulsantwort $h(I)$ mit $I = 0$ bis $N-1$ und der ungeraden Filterlänge N, und es ergibt sich, daß jeder 2. Wert identisch Null ist, ausgenommen der mittlere Hauptwert (s. hierzu auch Fig. 2 auf S. 233 in dem o.g. Aufsatz von Bellanger et al).

Die Figur 2b zeigt den Frequenzgang $|H|$. Man sieht, daß dieser Frequenzgang um die Frequenz fA/4 gegenüber dem Frequenzgang des Prototyp-Halb-Band-Filtersnach rechts verschoben ist. In die Figur 2b ist zusätzlich das Spektrum $|S_1|$ eines komplexen mit der Abtastfrequenz fA abgetasteten Eingangssignals $s_1(kT)$ eingezeichnet, das sich aufgrund der Abtastung mit fA in den Frequenzbereichen [m•fA, (m+1)•fA] mit m = ... -1, 0, +1 ... periodisch wiederholt. Das erfindungsgemäße Halb-Band-Filter ohne Abtastratenänderung würde also die Spektralanteile von $s_1(kT)$ zwischen fA/2 und fA und natürlich mit sämtlichen Wiederholungen unterdrücken. Eine Abtastratenhalbierung bringt nun die gewünschten Spektren, die jeweils im Raster von fA/2 = fA', also der neuen Abtastrate wiederholt werden, s. Fig. 2c.

An dieser Stelle sei erwähnt, daß man am Ausgang des Halb-Band-Filters den anderen Spektralanteil des komplexen Eingangssignals $s_1(kT)$ erhält, wenn der Frequenzgang des Prototyp-Halb-Band-Filters gemäß Figur 2a um -fA/4 oder, was gleichbedeutend ist, um +3fA/4 verschoben wird.

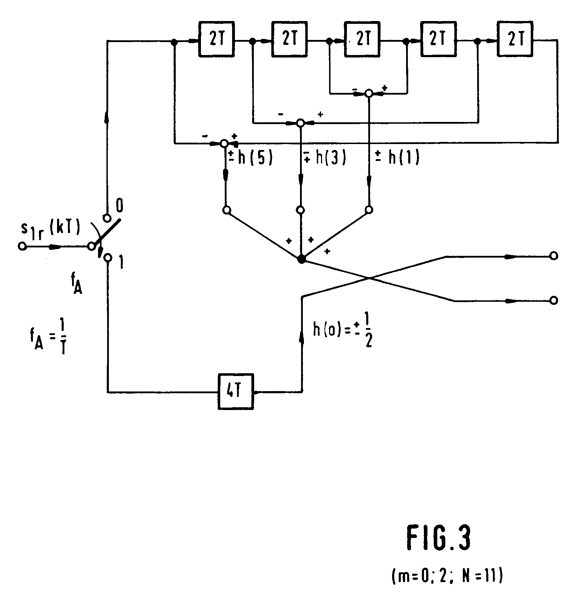

Die Figur 3 zeigt nun ein detaillierteres Ausführungsbeispiel eines erfindungsgemäßen Halb-Band-Filters. Zunächst sei jedoch noch etwas zu Fig. 2 gesagt, wonach ja die Abtastratenhalbierung erst nach der Filterung angesprochen wurde. Diese Reihenfolge des Vorgehens nach Fig. 2 wäre formal zu befolgen, jedoch kann gemäß der Erfindung das Halb-Band-Filter-Teil zur Verarbeitung des Real- und des Imaginärteils jeweils in 2 Zweige aufgeteilt werden, welche von vornherein schon jeweils mit jedem 2. Abtastwert des Eingangssignals versorgt werden. Dies bedeutet aber nichts anderes, als daß, wie auch im Blockschaltbild der Fig. 1 angegeben, die Abtastratenhalbierung direkt am Filtereingang erfolgen kann. Entsprechend enthalten die detaillierteren Schaltungsausführungen der Figuren 3 und 4 einen eingangsseitigen Demultiplexer-Schalter, welcher mit dem Eingangssignal einmal den oberen Zweig und zum anderen den unteren Zweig jeweils im Takte der Abtastrate fA' = fA/2 versorgt.

Sowohl Figur 3 als auch Figur 4 stellt beispielhaft eine Realisierung dar für eine Filterlänge N = 11. Dementsprechend enthält der untere Zweig ein Verzögerungsglied der Verzögerungszeit (N-3) • T/2 = 4T, während der obere Zweig eine Kette von 5 Verzögerungsgliedern der Verzögerungszeit 2T enthält. In Figur 3, die übrigens nur einen der beiden für Realteil- und Imaginärteilverarbeitung gleichen Filterteile zeigt, sind nun 2 Realisierungen dargestellt, nämlich für einen Modulationsphasenwinkel $\phi 0$ = 0 und $\phi 0$ = $\pi$ entsprechend m = 0 und m = 2.

Daa Ausgangssignal des Verzögerungsgliedes des unteren Zweiges wird mit h(0) = 1/2 bewertet (multipliziert) und ergibt damit den einen Beitrag zum Realteil $s_r$(2kT) des Ausgangssignals. Bei m = 2 wird mit -1/2 bewertet. Die weitere Verarbeitung des oberen Zweiges erfolgt nun derart, daß (N + 1)/4 = 3 Differenzsignale gebildet werden:

1. Differenzsignal = Eingangssignal des 1. minus Ausgangssignal des letzten Verzögerungsgliedes,

2. Differenzsignal = Eingangssignal des 2. minus Ausgangssignal des zweitletzten Verzögerungsgliedes und

3. Differenzsignal = Eingangssignal des 3. minus Ausgangssignal des drittletzten also des mittleren Verzögerungsgliedes.

Anschließend werden diese Differenzsignale bewertet (multipliziert), summiert und ergeben somit den einen Beitrag zum Imaginärteil des Ausgangssignals s(2kT). Die Bewertung erfolgt nach den folgenden Tabellen.

Beispiele für N = 11 und h(-I) = h(I) für I = 0, 1,...5, entsprechend dem Prototyp-Halb-Band-Filter gemäß Frequenzgang Figur 2a:

*Tabelle 1:*

*m = 0 (m = 2 mit jeweils anderem Vorzeichen der komplexen Koeffizienten*

$\underline{h}$ = Re($\underline{h}$) + jJm($\underline{h}$))

| I | -5 | -3 | -1 | 0 | 1 | 3 | 5 |
|---|---|---|---|---|---|---|---|
| Re($\underline{h}$) | 0 | 0 | 0 | h(0) | 0 | 0 | 0 |
| Jm($\underline{h}$) | -h(5) | h(3) | -h(1) | 0 | h(1) | -h(3) | h(5) |

*Tabelle 2:*

*m = 1 (m = 3 mit jeweils anderen Vorzeichen der komplexen Koeffizienten)*

| I | -5 | -3 | -1 | 0 | 1 | 3 | 5 |
|---|---|---|---|---|---|---|---|
| Re($\underline{h}$) | h(5) | -h(3) | h(1) | 0 | -h(1) | h(3) | -h(5) |
| Jm($\underline{h}$) | 0 | 0 | 0 | h(0) | 0 | 0 | 0 |

Die Realisierung gemäß Fig. 4 erfolgt in der gleichen Weise wie die nach der Figur 3, der Unterschied liegt allein im anderen Nullphasenwert $\phi 0$ = m • $\pi/2$ mit m = 1 und 3, was lediglich eine andere Bewertung und einen Tausch der Filterzweigausgänge zur Folge hat.

Die Figur 4 zeigt das komplette Halb-Band-Filter mit den beiden identischen Teilfiltern Fi, wobei das obere zur Verarbeitung des Realteils $S_{1r}$(kT) und das untere zur Verarbeitung des Imaginärteils $s_{1i}$(kT) dient. Die beiden Ausgangssignal-Paare an den Klemmen a, b sind in einer Ausgangsschaltung AS mit Differenz- und Summierglied verschaltet gemäß Gleichung (1), Patentanspruch 1, welche Ausgangsschaltung das komplexe Ausgangssignal $\underline{s}$(2kT) = $S_r$(2k) + $js_i$(2k) liefert.

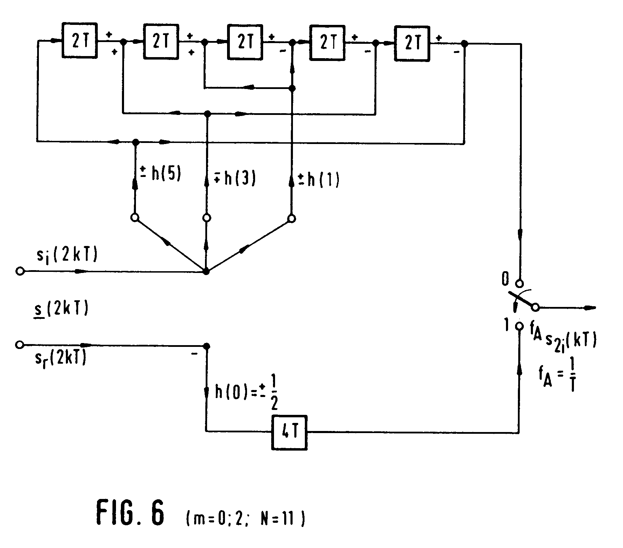

Die Figur 5 zeigt das Blockschaltbild für den umgekehrten Einsatz des Halb-Band-Filters nach Figur 1, nämlich zur Erzeugung eines komplexen Ausgangssignals aus einem komplexen Eingangssignal bei Abtastratenerhöhung. Hierzu hat eine Transposition der bisher vorgestellten Schaltungen zu erfolgen, was eine Umkehrung aller Pfeilrichtungen und ein Ersatz einer Verzweigung durch einen Addierer und umgekehrt sowie der Ersatz eines Demultiplexers durch einen Multiplexer zur Folge hat. In entsprechender Weise gehen das Schaltungsausführungsbeispiel der Figur 6 aus der Figur 3 und die Schaltung nach Figur 7 aus Figur 4 hervor.

**Patentansprüche**

1. Nichtrekursives Halb-Band-Filter mit komplexen Koeffizienten zum Verarbeiten eines komplexwertigen Eingangssignals s(kT) unter Halbierung der Abtastfrequenz fA = 1/T und zum Umwandeln dieses komplexwertigen Eingangssignals s(kT) in eine komplexwertiges Ausgangssignal $\underline{s}$(2kT), wobei seine Impulsantwort h(l), mit I = -(N-1)/2 bis (N-1)/2 und der ungeraden Filterlänge N, auf den komplexen Träger einer Frequenz von ±1/4 der Abtastfrequenz fA = 1/T moduliert wird zu

$$\underline{h}(l) = h(l) \cdot e^{j(\pm 2\pi l fA/4fA) + \varphi_0)} = j^{\pm l} \cdot e^{j\varphi_0} \cdot h(l)$$

und wobei die Nullphase $\phi_0$ dieses komplexen Trägers ganze Vielfache m von $\pi/2$ beträgt ($\phi_0$ = m . $\pi/2$ mit m = 0, 1, 2, 3, ...), dadurch gekennzeichnet, daß sein komplexwertiges Eingangssignal $s_1$(kT) = $s_{1r}$ + $js_{1i}$ mittels Faltung mit der modulierten Impulsantwort $\underline{h}$(l) in das komplexwertige Ausgangssignal

$$\underline{s}(2kT) = \underline{s}_1(2kT) * \underline{h}(l)$$
$$= s_{1r}(2k) * h_r(l) - s_{1i}(2k) * h_i(l)$$
$$+ j[s_{1r}(2k) * h_i(l) + s_{1i}(2k) * h_r(l)] \qquad (1)$$

mit k als laufendem Index umgewandelt wird.

2. Nichtrekursives Halb-Band-Filter, mit komplexen Koeffizienten zum Verarbeiten eines komplexwertigen Eingangssignals $\underline{s}$(2kT) und zur Verdoppelung der Abtastfrequenz fA' = 1/2T auf fA = 2fA' und zum Umwandeln dieses komplexwertigen Eingangssignals $\underline{s}$(2kT) in ein komplexwertiges Ausgangssignal s-(kT), wobei seine auf die erhähte Ausgangsabtastfrequenz fA = 2fA' bezogene Impulsantwort h(l), mit I = -(N-1)/2 bis (N-1)/2 und der ungeraden Filterlänge N, auf den komplexen Träger einer Frequenz von ±fA/4 = fA'/2 moduliert wird zu

$$\underline{h}(l) = h(l) \cdot e^{j(\pm 2\pi l fA/4fA) + \varphi_0)} = j^{\pm l} \cdot e^{j\varphi_0} \cdot h(l)$$

und wobei die Nullphase $\phi_0$ dieses komplexen Trägers ganze Vielfache m von $\pi/2$ beträgt ($\phi_0$ = m . $\pi/2$ mit m = 0, 1, 2, 3, ...), dadurch gekennzeichnet, daß sein komplexwertiges Eingangssignal s(2kT) mit k als laufendem Index mittels Faltung mit der modulierten Impulsantwort $\underline{h}$(l) in das komplexwertige Ausgangssignal

$$\underline{s}_1(kT) = \underline{s}(kT) * \underline{h}(l)$$
$$= s_r(k) * h_r(l) - s_i(k) * h_i(l)$$
$$- j\big[s_r(k) * h_i(l) + s_i(k) * h_r(l)\big] \qquad (2)$$

umgewandelt wird.

**3.** Nichtrekursives Halb-Band-Filter nach Anspruch 1, dadurch gekennzeichnet, daß jeder 2. Abtastwert des Real- und des Imaginärteils des Eingangssignals $\underline{s}_1(kT)$ jeweils in zwei ersten Zweigen in eine Kette von (N-1)/2 Verzögerungsgliedern der Verzögerungszeit 2T geleitet wird, daß jeweils Differenzsignale gebildet werden aus Ausgangssignal des letzten Verzögerungsgliedes minus Eingangssignal des 1. Verzögerungsgliedes = 1. Differenzsignal, Ausgangssignal des zweitletzten Verzögerungsgliedes minus Eingangssignal des 2. Verzögerungsgliedes = 2. Differenzsignal, Ausgangssignal des drittletzten Verzögerungsgliedes minus Eingangssignal des 3. Verzögerungsgliedes = 3. Differenzsignal usw., daß diese Differenzsignale einer Bewertung (Multiplikation) mit einem Wert h(l) der Impulsantwort unterworfen werden und anschließend summiert werden und dann einen 1. Beitrag entweder zum Real- bzw. Imaginärteil des Filterausgangssignals $\underline{s}(2kT)$ ergeben, daß jeweils in zwei zweiten Zweigen ein Verzögerungsglied mit der Verzögerungszeit $T\cdot(N-3)/2$ vorgesehen ist, in das jeder 2. gegenüber obigen Abtastwerten vesetzte Abtastwert des komplexen Eingangssignals geleitet wird und dessen Ausgangssignal, mit dem Wert h(0) bewertet, einen 2. Term zum Imaginär- bzw. Realteil des Filterausgangssignals $\underline{s}(2kT)$ ergibt.

**4.** Nichtrekursives Halb-Band-Filter nach Anspruch 3, mit N = 11 und m = 1, dadurch gekennzeichnet, daß das 1. Differenzsignal mit -h(5), das 2. Differenzsignal mit h(3) und das 3. mit -h(1) bewertet werden, daß h(0) = 1/2 ist (Fig. 4).

**5.** Nichtrekursives Halb-Band-Filter nach Anspruch 3, mit N = 11 und m = 3, dadurch gekennzeichnet, daß die Bewertung des 1. Differenzsignals mit h(5), des 2. mit -h(3), des 3. mit h(1) erfolgt, daß h(0) = -1/2 ist (Fig. 4).

**6.** Nichtrekursives Halb-Band-Filter nach Anspruch 3, mit N = 11 und m = 0, dadurch gekennzeichnet, daß die Bewertung des 1. Differenzsignals mit h(5), des 2. mit -h(3) und des 3. mit h(1) erfolgt und daß h(0) = 1/2 ist (Fig. 3).

**7.** Nichtrekursives Halb-Band-Filter nach Anspruch 3, mit N = 11 und m = 2, dadurch gekennzeichnet, daß die Bewertung des 1. Differenzsignals mit -h(5), des 2. mit h(3), des 3. mit -h(1) erfolgt und daß h(0) = -1/2 ist (Fig. 3).

**8.** Nichtrekursives Halb-Band-Filter nach Anspruch 2, dadurch gekennzeichnet, daß jeweils in 2 Zweigen (Fi) eine Kette von (N-1)/2 Verzögerungsgliedern der Verzögerungszeit 2T vorgesehen ist, daß im 1. Zweig der mit einem Wert h(l) der Impulsantwort bewertete Realteil $s_r(2kT)$ und im 2. Zweig der gleichermaßen bewertete Imaginärteil $s_i(2kT)$ dem 1. Verzögerungsglied dieser Kette zugeführt und vom Ausgangssignal des letzten Verzögerungsgliedes dieser Kette abgezogen wird, welches Differenzsignal im 1. Zweig jeden 2. Abtastwert des Realteils $s_{1r}(kt)$ und im 2. Zweig jeden 2. Abtastwert des Imaginärteils $s_{1i}(kT)$ des komplexen Filterausgangssignals $\underline{s}_2(kT)$ liefert, daß auf das Transversalsignal dieser Verzögerungsgliederkette an den weiteren Punkten zusätzliche mit einem Wert h(l) der Impulsantwort bewertete Augenblickswerte des Realteils $s_r(2kT)$ bzw. Imaginärteils $s_i(2kT)$ des Filtereingangssignals addiert werden, daß in beiden Zweigen jeweils ein weiteres Verzögerungsglied der Verzögerungszeit $T\cdot(N-3)/2$ vorgesehen ist, daß in dessen Eingang im 1. Zweig der mit h(0) bewertete Imaginärteil $s_i(2kT)$ und im 2. Zweig der mit -h(0) bewertete Realteil $s_r(2kT)$ eingegeben wird und dessen Ausgang im 1. Zweig jeden zeitlich versetzten 2. Abtastwert des Realteils des komplexen Filterausgangssignals $\underline{s}_2(kT)$ und im 2. Zweig den entsprechenden Wert des Imaginärteils liefert.

9. Nichtrekursives Halb-Band-Filter nach Anspruch 8, mit m = 0 und N = 11, dadurch gekennzeichnet, daß die Bewertung der zugeführten Augenblickswerte des Realteils $s_r$(2kT) bzw. des Imaginärteils $s_i$-(2kT) des komplexen Filtereingangssignals in den Ketten der beiden Zweige wie folgt erfolgt:

am Eingang des 1. Verzögerungsgliedes h(5),

am Eingang des 2. Verzögerungsgliedes -h(3),

am Eingang des 3. Verzögerungsgliedes h(1),

am Eingang des 4. Verzögerungsgliedes -h(1),

am Eingang des 5. Verzögerungsgliedes h(3) und

am Ausgang des 5. Verzögerungsgliedes -h(5) und

daß h(0) = 1/2 ist (Fig. 6).

**Claims**

1. A nonrecursive half-band filter including complex coefficients for processing a complex-valued input signal s(kT) while cutting the sampling frequency fA = 1/T in half and for converting this complex-valued input signal s(kT) into a complex-valued output signal $\underline{s}$(2kT), with its pulse response h($\ell$), where $\ell$ = -(N-1)/2 to (N-1)/2 and the filter length N is an odd integer, being modulated onto the complex carrier of a frequency of ±1/4 of the sampling frequency fA = 1/T so as to produce

$$\underline{h}(\ell) = h(\ell) \cdot e^{j(\pm 2\pi\ell fA/4fA) + \varphi_0)} = j^{\pm\ell} \cdot e^{j\varphi_0} \cdot h(\ell)$$

and wherein the zero phase $\phi_0$ of this complex carrier is a whole number multiple m of $\pi/2$ ($\phi_0$ = m • -$\pi$/2, where m = 0, 1, 2, 3, ...), characterised in that its complex-valued input signal $\underline{s}_1$(kT) = $s_{1r}$ + $js_{1i}$ is converted by means of convolution with the modulated pulse response $\underline{h}(\ell)$ into the complex-valued output signal

$$
\begin{aligned}
\underline{s}(2kT) \quad &= \underline{s}_1(2kT) * \underline{h}(\ell) \\
&= s_{1r}(2k) * h_r(\ell) - s_{1i}(2k) * h_i(\ell) \\
&\quad + j[s_{1r}(2k) * h_i(\ell) + s_{1i}(2k) * h_r(\ell)] \quad\quad (1)
\end{aligned}
$$

where k is a running index.

2. A nonrecursive half-band filter including complex coefficients for processing a complex-valued input signal s(2kT) and for doubling the sampling frequency fA' = 1/2T to fA = 2fA' and for converting this complex-valued input signal s(2kT) into a complex-valued output signal s(kT), with its pulse response h-($\ell$), where $\ell$ = -(N-1)/2 to (N-1)/2 and the filter length N is an odd integer, with respect to the increased output sampling frequency fA = 2fA', being modulated onto the complex carrier of a frequency of ±fA/4 = fA'/2 so as to produce

$$\underline{h}(\ell) = h(\ell) \cdot e^{j(\pm 2\pi\ell fA/4fA) + \varphi_0)} = j^{\pm\ell} \cdot e^{j\varphi_0} \cdot h(\ell)$$

and wherein the zero phase $\phi_0$ of this complex carrier is a whole number multiple m of $\pi/2$ ($\phi_0$ = m • $\pi$/2, where m = 0, 1, 2, 3, ...), characterised in that its complex-valued input signal s(2kT), where k is a running index, is converted by means of convolution with the modulated pulse response $\underline{h}(\ell)$ into the complex-valued output signal

$$
\begin{aligned}
\underline{s}_1(kT) \quad &= \underline{s}(kT) * \underline{h}(\ell) \\
&= s_r(k) * h_r(\ell) - s_i(k) * h_i(\ell) \\
&\quad - j[s_r(k) * h_i(\ell) + s_i(k) * h_r(\ell)] \quad\quad (2)
\end{aligned}
$$

3. A nonrecursive half-band filter according to claim 1, characterised in that every second sampling value of the real component and of the imaginary component of the input signal $s_1(kT)$ is conducted in two first branches into a chain of (N-1)/2 delay members having a delay of 2T; difference signals are formed from the output signal of the last delay member minus the input signal of the first delay member to equal the first difference signal, from the output signal of the penultimate delay member minus the input signal of the second delay member to equal the second difference signal, from the output signal of the third delay member from the end minus the input signal of the third delay member to equal the third difference signal, etc.;

these difference signals are subjected to weighting (multiplication) with a value $h(\ell)$ of the pulse response and are subsequently summed up and then furnish a first contribution either to the real component or to the imaginary component of the filter output signal $\underline{s}(2kT)$;

a delay member having a delay of T · (N-3)/2 is provided in each one of two second branches into which is conducted every second sampling value of the complex input signal, which is offset with respect to the above sampling values, and the output signal of said delay member is weighted with the value h(0) to produce a second term for the imaginary and the real component, respectively, of the filter output signal $\underline{s}(2kT)$.

4. A nonrecursive half-band filter according to claim 3, wherein N = 11 and m = 1, characterised in that the first difference signal is weighted with -h(5), the second difference signal with h(3), the third difference signal with -h(1), and h(0) = 1/2 (Figure 4).

5. A nonrecursive half-band filter according to claim 3, wherein N = 11 and m = 3, characterised in that the first difference signal is weighted with h(5), the second difference signal with -h(3), the third difference signal with h(1), and h(0) = -1/2 (Figure 4).

6. A nonrecursive half-band filter according to claim 3, wherein N = 11 and m = 0, characterised in that the first difference signal is weighted with h(5), the second difference signal with -h(3) and the third difference signal with h(1), and h(0) = 1/2 (Figure 3).

7. A nonrecursive half-band filter according to claim 3, wherein N = 11 and m = 2, characterised in that the first difference signal is weighted with -h(5), the second difference signal with h(3), the third difference signal with -h(1), and h(0) = -1/2 (Figure 3).

8. A nonrecursive half-band filter according to claim 2, characterised in that a chain of (N-1)/2 delay members having a delay of 2T is provided in each of two branches (Fi); in the first branch, the real component $s_r(2kT)$ weighted with a value $h(\ell)$ of the pulse response and, in the second branch, the identically weighted imaginary component $s_i(2kT)$ are fed to the first delay member of said chain and are subtracted from the output signal of the last delay member of said chain, with the difference signal furnishing every second sampling value of the real component $s_{1r}(kt)$ in the first branch and every second sampling value of the imaginary component $s_{1i}(kT)$ of the complex filter output signal $\underline{s}_2(kT)$ in the second branch;

the transversal signal of said chain of delay members is added at further points to additional momentary values of the real component $s_r(2kT)$ and of the imaginary component $s_i(2kT)$ of the filter input signal which momentary values are weighted with a value $h(\ell)$ of the pulse response;

a further delay member having a delay of T · (N-3)/2 is provided in each one of the two branches;

the input of said further delay member in the first branch receives the imaginary component $s_i(2kT)$ weighted with h(0) and the second branch receives the real component $s_r(2kT)$ weighted with -h(0), with the output of said further delay member furnishing, in the first branch, every second sampling value of the real component of the complex filter output signal $\underline{s}_2(kT)$ offset in time and, in the second branch, the corresponding value of the imaginary component.

9. A nonrecursive half-band filter according to claim 8, wherein m = 0 and N = 11, characterised in that the fed-in momentary values of the real component $s_r(2kT)$ and of the imaginary component $s_i(2kT)$ of the complex filter input signal are weighted as follows in the chains of the two branches:

at the input of the first delay member with h(5);
at the input of the second delay member with -h(3);
at the input of the third delay member with h(1);
at the input of the fourth delay member with -h(1);

at the input of the fifth delay member with h(3); and
at the output of the fifth delay member with -h(5);
and wherein h(0) = 1/2 (Figure 6).

## Revendications

1. Filtre demi-bande non récursif à coefficients complexes pour traiter un signal d'entrée de valeur complexe s(kT) avec division par deux de la fréquence d'échantillonnage fA = 1/T et pour convertir ce signal d'entrée de valeur complexe s(kT) en un signal de sortie de valeur complexe $\underline{s}$(2kT), filtre dans le cas duquel sa réponse impulsionnelle h(I), avec I = -(N-1)/2 à (N-1)/2 et avec la longueur impaire de filtre N, est modulée sur la porteuse complexe d'une fréquence de ±1/4 de la fréquence d'échantillonnage fA = 1/T pour donner

$$\underline{h}(I) = h(I) \cdot e^{j(\pm 2\pi I fA/4fA) + \varphi_0)} = j^{\pm I} \cdot e^{j\varphi_0} \cdot h(I)$$

et filtre dans le cas duquel la phase zéro $\phi_0$ de cette porteuse complexe vaut des multiples entiers m de $\pi/2$ ($\phi_0 = m \cdot \pi/2$ avec m = 0, 1, 2, 3,...) filtre caractérisé par le fait que son signal d'entrée de valeur complexe $s_1$ (kT) = $s_{1r}$ + $js_{1i}$, au moyen d'une multiplication complexe avec la réponse impulsionnelle modulée $\underline{h}$(I), est converti dans le signal de sortie de valeur complexe

$$\begin{aligned}
\underline{s}(2kT) &= \underline{s}_1(2kT) * \underline{h}(I) \\
&= s_{1r}(2k) * h_r(I) - s_{1i}(2k) * h_i(I) \\
&\quad + j[s_{1r}(2k) * h_i(I) + s_{1i}(2k) * h_r(I)]
\end{aligned} \qquad (1)$$

k étant l'indice courant.

2. Filtre demi-bande non récursif à coefficients complexes pour traiter un signal d'entrée de valeur complexe s(2kT) et pour doubler la fréquence d'échantillonnage fA' = 1/2T qui devient fA = 2fA' et pour convertir ce signal d'entrée de valeur complexe s(2kT) en un signal de sortie de valeur complexe s(kT), filtre dans le cas duquel sa réponse impulsionnelle h(I), avec I = -(N-1)/2 à (N-1)/2 et avec la longueur impaire de filtre N, rapportée à la fréquence d'échantillonage de sortie augmentée fA = 2fA' et avec sa valeur impaire de filtre N, est modulée sur la porteuse complexe d'une fréquence de +fA/4 = fA'/2 pour donner

$$\underline{h}(I) = h(I) \cdot e^{j(\pm 2\pi I fA/4fA) + \varphi_0)} = j^{\pm I} \cdot e^{j\varphi_0} \cdot h(I)$$

et filtre dans le cas duquel la phase zéro $\phi_0$ de cette porteuse complexe vaut des multiples entiers m de $\pi/2$ ($\phi_0 = m \cdot \pi/2$ avec m = 0, 1, 2, 3, ...), filtre caractérisé par le fait que son signal d'entrée de valeur complexe s(2kT), k étant l'indice courant, est converti, au moyen d'une multiplication complexe avec la réponse impulsionnelle modulée $\underline{h}$(I) en le signal de sortie de valeur complexe

$$\begin{aligned}
\underline{s}_1(kT) &= \underline{s}(kT) * \underline{h}(I) \\
&= s_r(k) * h_r(I) - s_i(k) * h_i(I) \\
&\quad - j[s_r(k) * h_i(I) + s_i(k) * h_r(I)]
\end{aligned} \qquad (2)$$

8

3. Filtre demi-bande non récursif selon la revendication 1, caractérisée par le fait que l'on envoie chaque fois une sur deux des valeurs d'échantillonnage de la partie réelle et de la partie imaginaire du signal d'entrée $s_1(kT)$ dans deux premières branches d'une chaîne de (N-1)/2 éléments temporisation de la durée de temporisation 2T,

par le fait que l'on forme chaque fois des signaux de différence à partir du signal de sortie du dernier élément de temporisation moins le signal d'entrée du premier élément de temporisation, ce qui donne le premier signal de différence, à partir du signal de sortie du pénultième élément de temporisation moins le signal d'entrée du second élément de temporisation , ce qui donne le second signal de différence, à partir du signal de sortie de l'antépénultième élément de temporisation moins le signal d'entrée du troisième élément de temporisation, ce qui donne le troisième signal de différence, etc.,

par le fait que l'on soumet ces signaux de différence à une valorisation (multiplication) par une valeur h(l) de la réponse impulsionnelle et qu'ensuite on les additionne, ce qui donne une première contribution soit à la partie réelle, soit à la partie imaginaire du signal de sortie du filtre s(2kT),

par le fait que, respectivement, dans deux secondes branches est prévu un élément de temporisation d'une durée de temporisation T•(N - 3)/2 dans lequel on envoie une sur deux valeur d'échantillonnage, décalée par rapport aux valeurs d'échantillonnage ci-dessus, du signal d'entrée complexe et dont le signal de sortie, valorisé par la valeur h(0), donne un second terme pour la partie imaginaire ou la partie réelle du signal de sortie du filtre s(2kT).

4. Filtre demi-bande non récursif selon la revendication 3, avec N = 11 et m = 1, caractérisé par le fait que l'on valorise le premier signal de différence par -h(5), le second signal de différence, par h(3) et le troisième par -h(1) et par le fait que h(0) = 1/2 (figure 4).

5. Filtre demi-bande non récursif selon la revendication 3 avec N = 11 et m = 3, caractérisé par le fait que la valorisation du premier signal de différence se fait avec h(5), celle du second, avec -h(3), celle du troisième, avec h(1), et par le fait que h(0) = -1/2 (figure 4).

6. Filtre demi-bande non récursif selon la revendication 3, avec N = 11 et m = 0, caractérisé par le fait que la valorisation du premier signal de différence se fait avec h(5), celle du second avec -h(3) et celle du troisième avec h(1) et par le fait que h(0) = 1/2 (figure 3).

7. Filtre demi-bande non récursif selon la revendication 3, avec N = 11 et m = 2, caractérisé par le fait que la valorisation du premier signal de différence se fait avec -h(5), celle du second avec h(3), celle du troisième avec -h(1) et par le fait que h(0) = -1/2 (figure 3).

8. Filtre demi-bande non récursif selon la revendication 1, caractérisé par le fait qu'il est prévu dans chacune des deux branches (Fi) une chaîne de (N-1)/2 éléments de temporisation d'une durée de temporisation 2T, par le fait que dans la première branche on amène au premier élément de temporisation de cette chaîne la partie réelle $S_r(2kT)$, valorisée avec une valeur h(l) de la réponse impulsionnelle et qu'on la soustrait du signal de sortie du dernier élément de temporisation de cette chaîne et que, dans la seconde branche, on amène à ce premier élément de temporisation de cette chaîne la partie imaginaire $s_i(2kT)$, valorisée de la même façon et qu'on la soustrait également du signal de sortie du dernier élément de temporisation, le signal de différence obtenu à la première branche fournissant une sur deux des valeurs d'échantillonnage de la partie réelle $S_{1r}(kT)$ du signal complexe de sortie du filtre $s_2(kT)$ et le signal de différence obtenu à la seconde branche fournissant une sur deux des valeurs d'échantillonnage de la partie imaginaire $s_{1i}(kT)$ de ce même signal complexe de sortie,

par le fait qu'au signal transversal de cette chaîne d'éléments de temporisation, en d'autres points, on ajoute des valeurs instantanées supplémentaires, valorisées avec une valeur h(l) de la réponse impulsionnelle, de la partie réelle $s_r(2kT)$ ou de la partie imaginaire $s_i(2kT)$ du signal d'entrée du filtre,

par le fait que dans chacune des deux branches est prévu un autre élément de temporisation d'une durée de temporisation T • (N-3)/2, par le fait qu'à l'entrée de cet élément de temporisation de la première branche on entre la partie imaginaire $s_i(2kT)$, valorisée avec h(0) et, dans celui de la seconde branche, on entre la partie réelle $s_r(2kT)$ valorisée avec -h(0) et par le fait que la sortie de cet élément de temporisation de la première branche fournit une sur deux, décalée dans le temps, des valeurs d'échantillonnage de la partie réelle du signal complexe de sortie du filtre $s_2(kT)$ et que la sortie de celui de la seconde branche fournit la valeur correspondante de la partie imaginaire.

**9.** Filtre demi-bande non récursif selon la revendication 8, avec m = 0 et N = 11, caractérisé par le fait que la valorisation des valeurs instantanées, amenées dans les chaînes des deux branches, dela partie réelle $s_r(2kT)$ ou de la partie imaginaire $s_i(2\,kT)$ du signal complexe d'entrée du filtre se fait comme suit:

à l'entrée du premier élément de temporisation, h(5),

à l'entrée du second élément de temporisation, -h(3),

à l'entrée du troisième élément de temporisation, h(2),

à l'entrée du quatrième élément de temporisation, -h(1),

à l'entrée du cinquième élément de temporisation, h(3) et

à la sortie du cinquième élément de temporisation, -h(5) et

par le fait que h(0) = 1/2 (figure 6).

Halbband - Filter (Prototyp)

FIG. 2

FIG.1

$T = 1/f_A$

FIG. 5

**FIG.3**

$(m=0;2; N=11)$

m = 1　und　m = 3　　für N = 11

↓ 2 Verminderung

**FIG. 4**

(m = 1; 3 ; N = 11 )

FIG. 6  (m=0;2; N=11)

**FIG. 7**
$(m=1;3; N=11)$